# EUROPEAN PATENT APPLICATION

(11) **EP 2 063 463 A1**
(43) Date of publication of application: **27.05.2009**
(21) Application number: 07806776.6
(22) Date of filing: 05.09.2007
(51) Int. Cl.: H01L 21/3065

(54) **DRY ETCHING METHOD**

(30) Priority: 11.09.2006 JP 2006245304
(71) Applicant: Ulvac, Inc., Chigasaki-shi Kanagawa 253-8543 (JP)
(72) Inventor: MORIKAWA, Yasuhiro, Susono-shi Shizuoka 410-1231 (JP); SUU, Koukou, Susono-shi Shizuoka 410-1231 (JP)
(74) Representative: AMMANN PATENTANWÄLTE AG BERN
(86) International application number: PCT/JP2007/067334
(87) International publication number: WO 2008/032627

(57) **Abstract**

The object of the present invention is to provide a dry etching method which permits the reduction of the amount of any etching product formed during the etching process to thus improve the in-plane etching uniformity with respect to an object to be etched. The dry etching method comprises the steps of providing an electrode equipped with an electrode-presser member which at least comprises a surface layer composed of an yttrium- containing oxide and which is disposed on the peripheral region of the upper surface of the electrode, placing a substrate on the electrode and then subjecting the substrate to dry etching, while preventing the formation of any etching product at the peripheral region of the electrode.

## Description

### Technical Field

The present invention relates to a dry etching method and more particularly to a dry etching method which makes use of an electrode provided with a specific electrode-presser member.

### Background Art

In the dry etching process, it is common that an electrode used in the dry etching chamber is provided with an electrode-presser member such as an outer peripheral ring which is fitted to the periphery of an electrode in order to prevent the peripheral portion of the electrode from the consumption thereof through etching during the etching process. However, high-frequency (RF) waves or energy are likewise applied even to the electrode-presser member during the etching process. Therefore, this member is also etched off during the process and the products formed through the etching are scattered within the vacuum chamber of the etching apparatus. As a result, the scattering of such products may highly and adversely affect the in-plane etching uniformity throughout the whole surface of a substrate as an object to be etched.

For instance, when the etching process is carried out using a fluorine atom-containing gas based etching gas and the foregoing outer peripheral ring as an electrode-presser member is prepared from, for instance, a quartz or silicon material, not only the substrate, but also the outer peripheral ring are etched during the etching process so that the peripheral ring is thus wasted or consumed through the etching thereof. For this reason, a problem arises such that a great deal of etching products are in turn formed from the outer peripheral ring and discharged form its vicinity and that the products are again incident upon the substrate to thus give rise to the acceleration or reduction of the etching rate. Alternatively, another problem likewise arises such that the products may prevent the incidence of ions and/or radicals originated from the plasma source upon the substrate to thus suppress or control the etching rate. Such phenomena would accordingly result in the occurrence of a variety of demerits. For instance, the vacuum chamber and, in its turn, the etching apparatus would highly frequently require their maintenance.

Incidentally, it has been known that a substrate-presser for pressing the edge of the substrate against a substrate-placing table for supporting the same within a vacuum chamber is disposed in the vicinity of the substrate-placing table (see, for instance, Patent Document 1 specified below). In this case, however, the prior art never refers to or teach the protection of the peripheral region of the substrate-placing table from any etching by the disposition of such a substrate-presser and likewise refers to the materials for the substrate-presser and their quality.

Patent Document 1: Japanese Un-Examined Patent Publication Hei 7-76774 (see, the section entitled "What is claimed is:").

### Disclosure of the Invention

### Problems That the Invention is to Solve

Accordingly, it is an object of the present invention to solve the foregoing problems associated with the conventional dry etching techniques and more specifically to provide a dry etching method which permits the reduction of the amount of any undesirable etching product formed during the etching process to thus improve the in-plane etching uniformity of a substrate as an object to be etched by making an electrode-presser member as an outer peripheral ring using a specific material.

### Means for Solving the Problems

The dry etching method according to the present invention comprises the steps of placing a substrate on an electrode disposed within a vacuum chamber and then subjecting the substrate to dry etching, wherein the dry etching is carried out using an electrode provided with an electrode-presser member which at least comprises a surface layer composed of an yttrium-containing oxide and which is disposed on the peripheral portion of the upper surface of the electrode. The disposition of such an electrode-presser member would permit the inhibition of the formation of any etching product originated from the electrode material in the peripheral region thereof and likewise permit the implementation of the dry etching process while ensuring the excellent in-plane etching uniformity throughout the whole surface of the substrate.

Preferably, the aforementioned electrode-presser member may be a member completely constituted by an yttrium-containing oxide or it may be a member, the entire surface of which is covered with a film of an yttrium-containing oxide.

The foregoing electrode-presser member preferably used herein is, for instance, one which is constituted by quartz, Al₂O₃ or AlN and the whole surface of which is covered with a film of an yttrium-containing oxide.

The foregoing electrode-presser member is preferably one which is manufactured by forming a film of an yttrium-containing oxide on the whole surface of an electrode-presser member according to the spraying or thermal spraying technique, the CVD technique or the sputtering technique.

Alternatively, the foregoing electrode-presser member is preferably one constituted by a sintered body of an yttrium-containing oxide.

Preferably, the yttrium-containing oxide is an yttrium oxide and the purity thereof falls within the range of from 99.5 to 99.9%.

The foregoing yttrium-containing oxide is preferably an yttrium oxide such as transparent Y₂O₃.

### Effects of the Invention

The dry etching method according to the present invention would permit the achievement of such effects that, in the dry etching process, the amount of the etching products originated from the peripheral region of the electrode can be reduced and that the in-plane etching uniformity of the substrate as an object to be etched can significantly be improved.

### Brief Description of the Drawings

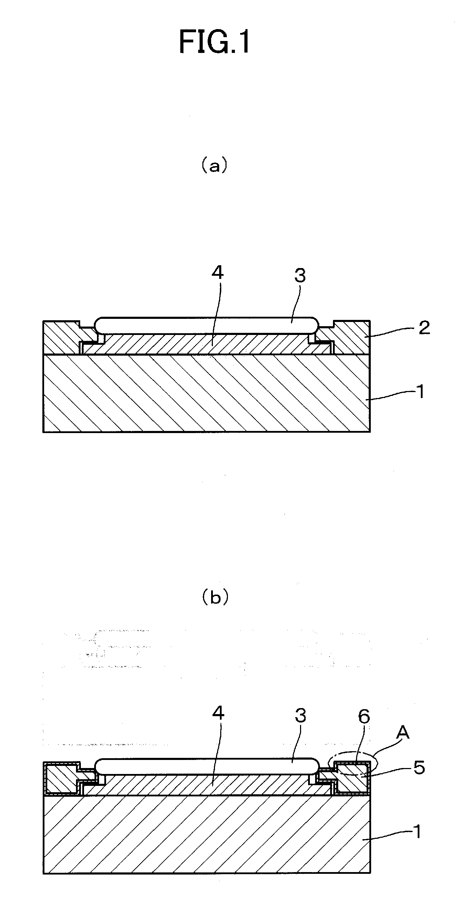

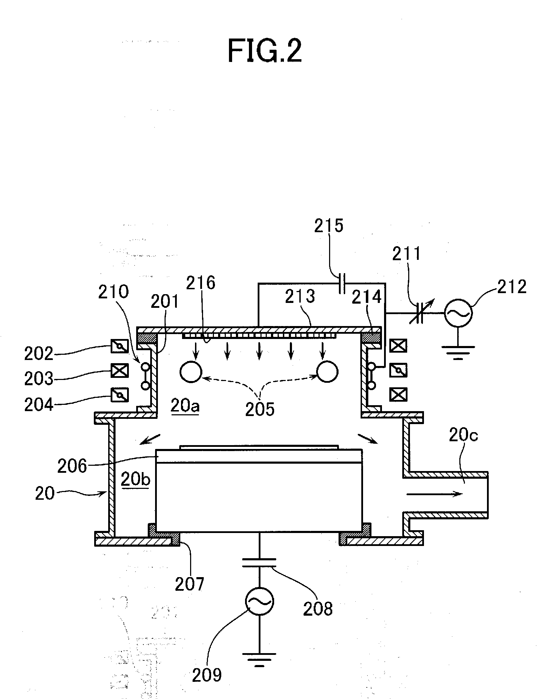

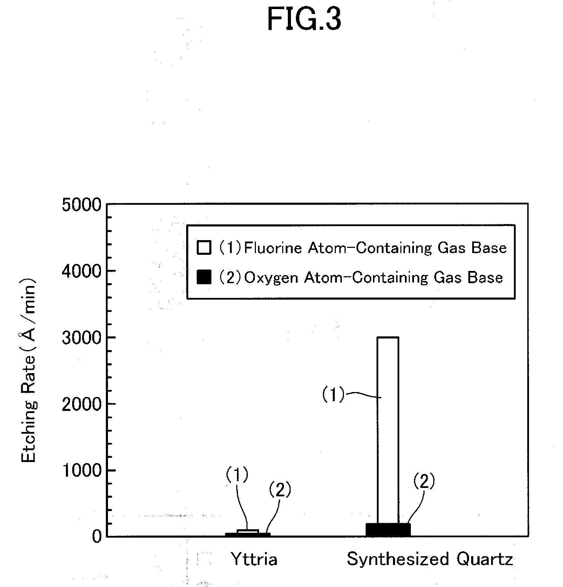

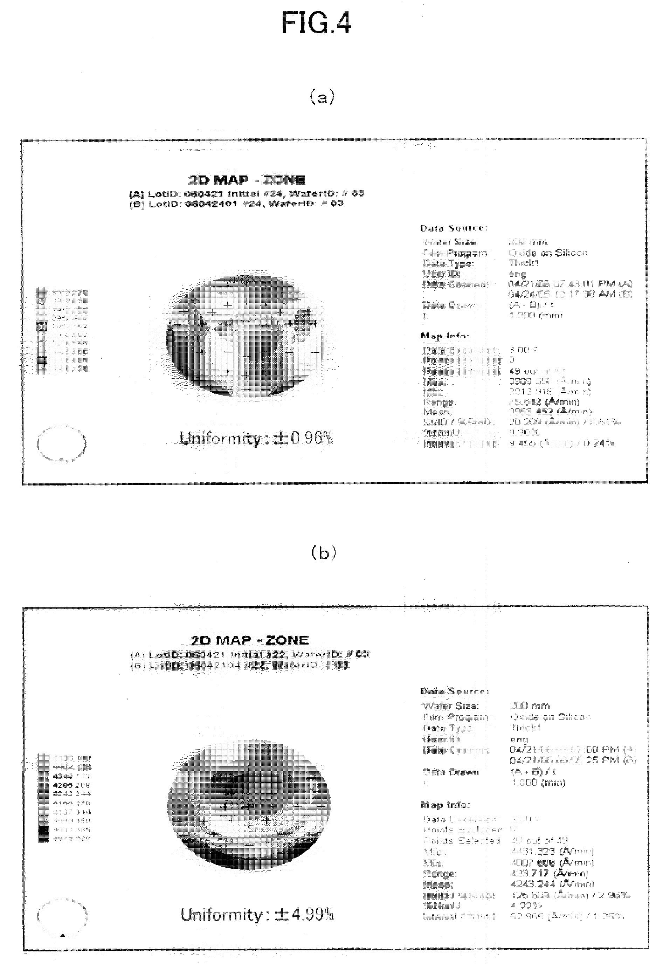

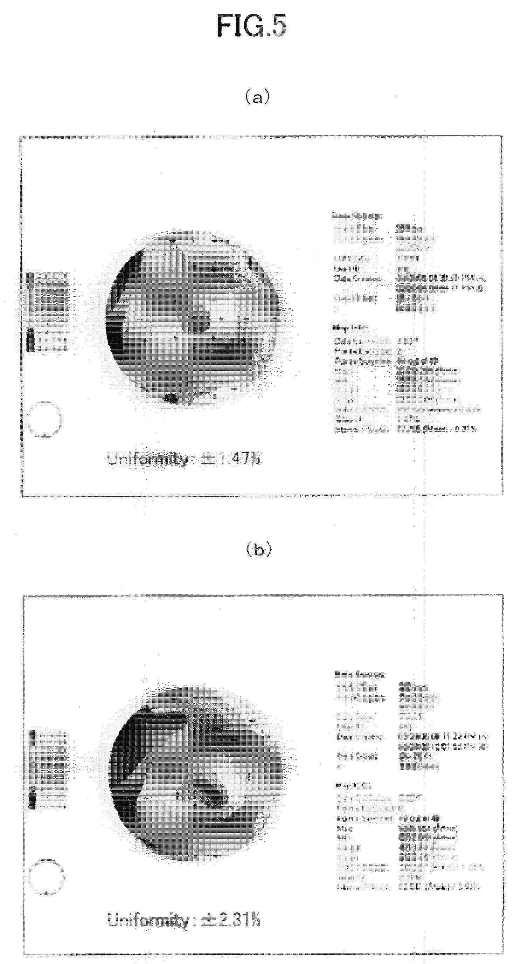

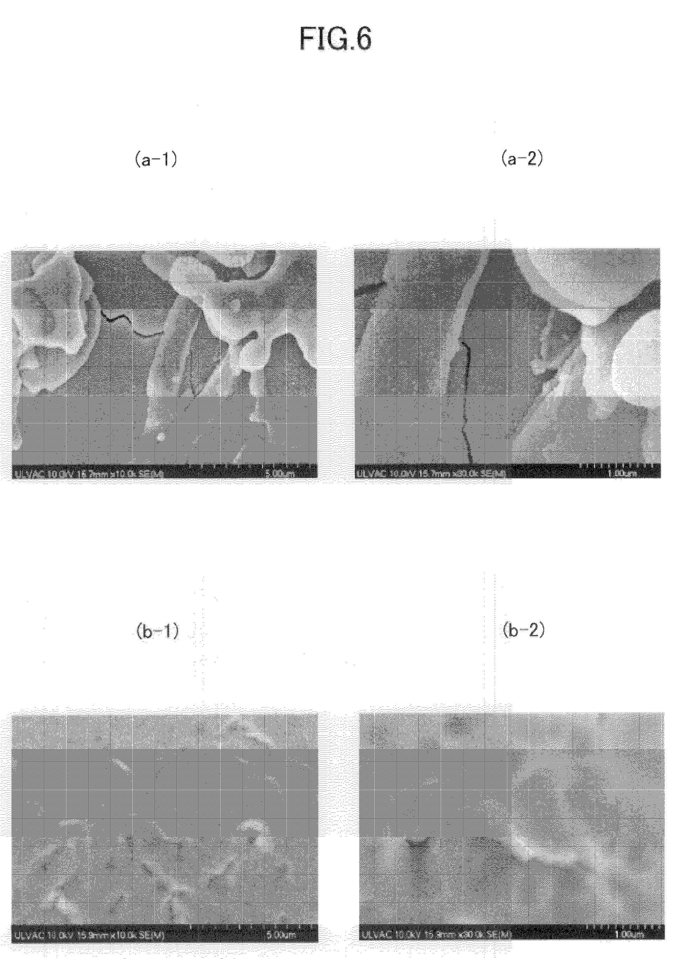

Fig. 1 is a cross sectional view schematically illustrating the relation between an electrode arranged within a vacuum chamber of a dry etching apparatus and an electrode-presser member which is disposed on the peripheral portion of the upper surface of the electrode, wherein the panel (a) shows an embodiment in which the electrode-presser member is constituted by yttria, while the panel (b) shows another embodiment in which the electrode-presser member is provided with, on its surface, a film of yttria. Fig. 2 is a diagram schematically illustrating the construction of an embodiment of the etching apparatus which can be used in the dry etching method according to the present invention. Fig. 3 is a graph showing the difference in the etching rate between different materials for forming the electrode-presser member. Fig. 4 is a diagram showing the in-plane etching uniformity observed on the surface of a substrate when using a fluorine atom-containing gas based etching gas, wherein the panel (a) shows the in-plane etching uniformity observed when using an electrode-presser member constituted by an yttria bulk, while the panel (b) likewise shows the in-plane etching uniformity observed when using an electrode-presser member constituted by a synthesized quartz. Fig. 5 is a diagram showing the in-plane etching uniformity observed on the surface of a substrate when using a oxygen atom-containing gas based etching gas, wherein the panel (a) shows the in-plane etching uniformity observed when using an electrode-presser member constituted by an yttria bulk, while the panel (b) likewise shows the in-plane etching uniformity observed when using an electrode-presser member constituted by a synthesized quartz. Fig. 6 shows SEM images each illustrating the surface of an electrode-presser member obtained after the completion of the etching process carried out in Example 2, wherein the panels (a-1) and (a-2) are images each corresponding to the surface of an electrode-presser member provided with a sprayed yttria film formed on one side thereof, while the panels (b-1) and (b-2) are images each corresponding to the surface of an electrode-presser member provided with a sprayed yttria film formed on the whole surface thereof.

### Best Mode for Carrying Out the Invention

An embodiment of the dry etching method according to the present invention comprises the steps of placing, by means of, for instance, an electrostatic chucking means or a clamping means, a substrate on an electrode which is disposed within a vacuum chamber and which is provided with, on its upper surface, an electrode-presser member for covering the peripheral region on the upper surface of the electrode to thus prevent the generation of any etching product originated from the electrode materials in the peripheral region thereof; and then subjecting the substrate to dry etching with the use of an etchant generated by the action of a plasma source while suppressing the formation of any etching product.

According to the method of the present invention, the conventionally used electrode-presser member, which is simply composed of a dielectric material selected from the group consisting of quartz, Al₂O₃ and AlN, is replaced with an electrode-presser member which is composed of a sintered body of an yttrium-containing oxide such as yttrium oxide (yttria) inclusive of transparent Y₂O₃, or an electrode-presser member which is composed of a dielectric material selected from the group consisting of quartz, Al₂O₃ and AlN and the whole surface of which is covered with a film of an yttrium-containing oxide such as yttria, whereby the amount of the etching products possibly originated from the electrode and the conventional electrode-presser member can significantly be reduced by the use of such an electrode-presser member of the present invention. In this respect, a film of yttria may further be formed on the surface of the electrode-presser member composed of a sintered body of yttria. Moreover, yttria may be replaced with another yttrium-containing oxide, for instance, a double oxide such as 3 Y₂O₃ · 5 Al₂O₃.

The foregoing sintered body of yttria is not limited to any particular one and it may be prepared according to any known method such as that disclosed in Japanese Un-Examined Patent Publication (hereunder simply referred to as "J.P. KOKAI") Hei 11-189413. For instance, the sintered body may be one prepared by adding a basic agent to an yttrium salt-containing solution to thus form particles of aggregated yttrium hydroxide, then adding a sulfate ion-containing compound to the particles, calcinating the aggregated particles, molding powder thereof thus obtained which is quite susceptible to sintering and firing the resulting powdery product or compact within a desired atmosphere to thus give an intended sintered body.

The foregoing yttria film thus formed on the electrode-presser member should have a sufficiently high adhesive force to the surface thereof and it may be formed on the whole surface of the member according to the spraying technique, the CVD technique or the sputtering technique. Therefore, the thickness of the yttria film to be formed on the member preferably ranges from about 100 to 300µm. If the thickness thereof falls within the range specified above, there would never be observed any removal (peeling off) of the film from the member during the sputtering operation.

The foregoing yttria film can be formed according to the spraying technique, but the film-forming technique is not restricted to any particular one and the film may be formed according to any knownmethod, for instance, that disclosed inJ.P. KOKAI 2003-166043. More specifically, a highly adhesive and dense plasma-sprayed yttria film having a desired film thickness can be formed at a desired temperature according to the plasma spraying technique such as any known reduced pressure-plasma spraying technique.

Moreover, when the yttria film is formed according to the foregoing CVD technique or the sputtering technique, the film-forming method can be carried out using the known process conditions.

In the case of the sputtering technique, an yttria film which is excellent in the adhesion to a substrate and likewise excellent in the denseness and which has a desired film thickness can be formed on the whole surface of the substrate by placing the substrate on a substrate-holder, evacuating a sputtering chamber to a high degree of vacuum using a vacuum pump, introducing argon gas to a pressure of 6.7×10⁻² Pa through a gas-introduction port, then starting an RF power source to induce or generate a high- frequency electric voltage, applying an RF sputtering electric power of 1.0 kW to a target for forming an yttria film, and subjecting the substrate to the RF magnetron sputtering while establishing a magnetic field parallel to the surface of the substrate by operating a magnetic circuit. In this respect, it is preferred to maintain the temperature of the substrate to a level on the order of 270°C through the use of a heater for heating the substrate.

In the case of the CVD technique, an yttria film which is excellent in the adhesion to a substrate and likewise excellent in the denseness and which has a desired film thickness can be formed on the whole surface of the substrate by the use of Y(C₁₁H₁₉O₂)₃ as a precursor material for the film, nitrogen gas (10 sccm) as a carrier gas and O₂ gas (500 to 1000 sccm) as a diluent gas, and by carrying out the CVD film-forming process under the following conditions: a substrate temperature ranging from 400°C to 500°C; and a pressure in the chamber ranging from 1 Torr to 10 Torr.

The dry etching apparatus used for carrying out the dry etching method according to the present invention is not restricted to any specific one insofar as it is a known dry etching apparatus equipped with a vacuum chamber. In this respect, the relation between an electrode arranged within this vacuum chamber and an electrode-presser member which is disposed on the upper surface of the electrode is shown in Fig. 1 attached hereto. As will be seen from Fig. 1, the aforementioned electrode-presser member 2 is disposed at the peripheral region on the upper surface of the electrode 1. This electrode-presser member 2 may be a sintered body of an yttria bulk (Fig. 1(a)) or a member which is composed of an electrode-presser member 2 made of a dielectric material and an yttria film formed, on the whole surface of the member, according to the spraying technique, the CVD technique or the sputtering technique (Fig. 1(b)). A substrate 3 as an object to be etched is placed on the electrode 1 in such a manner that the substrate is brought into close contact with the electrode using an electrostatic chucking means 4 and the substrate is then subjecting to a known dry etching treatment.

The dry etching apparatus in which an electrode provided with the foregoing electrode-presser member is disposed may be any known dry etching apparatus (such as those disclosed in, for instance, J.P. KOKAI 2002-343775) and a specific example thereof may be the apparatus as shown in Fig. 2.

In the etching apparatus shown in Fig. 2, the reference numeral 20 represents a vacuum chamber, which is composed of an upper plasma-generating section 20a and a lower substrate electrode section 20b, and the latter section 20b is provided with an exhaust port 20c, which is in turn connected to an appropriate exhaust system. The plasma-generating section 20a is provided with a cylindrical side wall 201 made of a dielectric material, three magnetic field-establishing coils 202, 203 and 204, which constitute a magnetic field-generating means for establishing a magnetic neutral loop within the vacuum chamber 20, are arranged on the outside of the dielectric side wall 201 and these coils thus form a magnetic neutral loop 205 within the plasma-generating section 20a positioned at the upper part of the vacuum chamber 20. A substrate electrode 206 is disposed at the lower part of the vacuum chamber 20 through a member 207 made of an electrical insulator and the substrate electrode 206 is connected to a high-frequency power source 209 for applying an RF bias voltage through a blocking condenser 208.

This etching apparatus is so designed that two high-frequency coils 210 for the generation of plasma are arranged between the intermediate magnetic coil 203 and the outside of the dielectric side wall 201, these high-frequency coils 210 are connected to a high-frequency power source 212 through a variable condenser 211 and the foregoing three magnetic coils can apply, to the plasma-generating section 20a, an alternating electric field along the magnetic neutral loop 205 which is formed within the plasma-generating section 20a positioned at the upper part of the vacuum chamber 20 to thus generate a discharge plasma in the magnetic neutral loop.

The roof 213 of the plasma-generating section 20a positioned at the upper part of the vacuum chamber 20 is air-tightly fixed to an upper flange of the dielectric side wall 201 through an electrical insulator member 214 to thus constitutes a counter electrode. In addition, the inner wall of the roof 213 is composed of a carbonaceous material. In this respect, an electric power supply passage is branched in the course thereof extending from the high-frequency power source 212 for the generation of plasma to the high-frequency antenna coil 210 through the variable condenser 211 so that a part of the high-frequency electric power can be applied, through a condenser 215, to the roof 213 which can serve as the counter electrode and that the counter electrode can thus generate a self-bias.

Furthermore, the plasma-generating section 20a positioned at the upper part of the vacuum chamber 20 is provided with a gas-introduction port 216 for the introduction of an etching gas into the vacuum chamber 20. In this connection, this gas-introduction port 216 is connected to an etching gas-supply source through a gas-supply passage and a gas flow rate-controlling unit for controlling the flow rate of the etching gas, although such a construction is not depicted in this figure.

### [Example 1]

Using an etching apparatus as shown in Fig. 2 having an electrode 1 disposed or incorporated into the same, which was provided with an electrode-presser member 2 as shown in Fig. 1(a) (a member constituted by an yttria bulk), a quartz substrate 3 was placed on the electrode 1 in such a manner that the substrate was closely fitted to the electrode by means of an electrostatic chucking means and the substrate was etched under fluorine atom-containing gas based etching process conditions and the details thereof were as follows:

The substrate was etched by the introduction of an etching gas (a mixed gas having a ratio: C₄F₈/CHF₃ = 10/116 (sccm)) under etching process conditions such as a high-frequency power source (13.56 MHz) for the plasma-generation at an electric power of 1500 W (antenna power) and a high-frequency power source (12.56 MHz) for the substrate-biasing at an electric power of 500 W (bias power), while inducing discharges under a pressure of 0.67 Pa at a set temperature of 0°C for a predetermined period of time.

In addition, by way of comparison, the substrate was etched under oxygen atom-containing gas based etching process conditions and the details thereof were as follows: More specifically, the substrate was etched by the introduction of an etching gas (a mixed gas having a ratio: O₂/CF₄ = 95/5 (sccm)) under etching process conditions such as a high-frequency power source (13.56 MHz) for the plasma-generation at an electric power of 1200 W (antenna power) and a high-frequency power source (12.56 MHz) for the substrate-biasing at an electric power of 600 W (bias power), while inducing discharges under a pressure of 0.67 Pa at a set temperature of -10°C for a predetermined period of time.

Further, by way of comparison, the substrate was likewise etched under the fluorine atom-containing gas based etching process conditions and the oxygen atom-containing gas based etching process conditions identical to those used above, while using an electrode-presser member composed of a synthesized quartz material.

The results are plotted on Fig. 3, which were obtained by carrying out the etching procedures using a fluorine atom-containing gas based etching gas and an oxygen atom-containing gas based etching gas while using an electrode-presser member constituted by an yttria bulk and an electrode-presser member composed of a synthesized quartz material, respectively. In Fig. 3, the etching rate (Å/min) is plotted as ordinate.

The data plotted on Fig. 3 clearly indicate that the electrode-presser member constituted by an yttria bulk is almost not etched in both cases wherein the etching is carried out under the foregoing two kinds of gas based etching conditions, as compared with the results observed for the case in which the electrode-presser member composed of a synthesized quartz material is used and accordingly it would be concluded that the method of the present invention can significantly reduce the amount of etching products which may be formed during the dry etching process.

The substrate etched using a fluorine atom-containing gas based etching gas was inspected for the in-plane etching uniformity on the surface of the substrate. The results thus obtained are shown in Fig. 4. In this connection, the panel (a) of Fig. 4 shows the in-plane etching uniformity observed when using an electrode-presser member constituted by an yttria bulk, while the panel (b) shows the in-plane etching uniformity observed when using an electrode-presser member constituted by a synthesized quartz material. Further, Fig. 5 is a diagram showing the in-plane etching uniformity observed on the surface of the substrate when using an oxygen atom-containing gas based etching gas. In this respect, the panel (a) of Fig. 5 shows the in-plane etching uniformity observed when using an electrode-presser member constituted by an yttria bulk, while the panel (b) shows the in-plane etching uniformity observed when using an electrode-presser member constituted by a synthesized quartz material.

As will be clear from the results as shown in Fig. 4 (a) and Fig. 5(a), the in-plane etching uniformity was found to be ±0.96% for the case which made use of the fluorine atom-containing gas based etching gas and ±1.47% for the case which made use of the oxygen atom-containing gas based etching gas, when using the electrode-presser member constituted by an yttria bulk. On the other hand, the results as shown in Fig. 4(b) and Fig. 5(b) clearly indicate that the in-plane etching uniformity was found to be ±4.99% for the case which made use of the fluorine atom-containing gas based etching gas and ±2.31% for the case which made use of the oxygen atom-containing gas based etching gas, when using the electrode-presser member constituted by a synthesized quartz material. From the foregoing, it would be concluded that the surface of the etched substrate is excellent in its in-plane etching uniformity when using an electrode-presser member constituted by an yttria bulk.

When comparing the results shown in Fig. 4 with those shown in Fig. 5, it is found that the etching rate is apt to be reduced at the peripheral region of the substrate when using an electrode-presser member constituted by a synthesized quartz material. It would be considered that this is because the etchant generated by the action of the plasma source is consumed by the quartz at the peripheral region of the substrate to thus reduce the quantity of the etchant at the peripheral region and as a result, the etching rate observed at the peripheral region is reduced. On the other hand, when using an electrode-presser member constituted by an yttria bulk, there is not observed any reduction of the etching rate at the peripheral region of the substrate and the substrate can thus be etched quite uniformly throughout the surface thereof with the in-plane etching uniformity on the order of about ±1%.

### [Example 2]

An yttria film having a thickness of 100µm was formed on the both sides (the whole surface including the region which was brought into close contact with the electrode) or one side (only the surface which was never brought into close contact with the electrode) of an electrode-presser member made of a synthetic quartz material according to the known reduced pressure plasma spraying technique to thus give each corresponding electrode-presser member. Using the fluorine atom-containing gas based etching gas used in Example 1, these substrates were etched under the same etching process conditions used in Example 1.

Fig. 6 shows SEM images illustrating the surface of an electrode-presser member obtained after the completion of the etching process. In Fig. 6, the images (a-1) and (a-2) are images each corresponding to the upper surface portion (the part A as shown in Fig. 1(b)) of the electrode-presser member provided with a plasma-sprayed yttria film formed on one side thereof, while the images (b-1) and (b-2) are images each corresponding to the upper surface portion (the part A as shown in Fig. 1(b)) of an electrode-presser member provided with a plasma-sprayed yttria film formed on the whole surface thereof. As will be clear from the results shown in Figs. 6(a-1), (a-2), (b-1) and (b-2), cracks are formed on the surface when forming a plasma sprayed-film only on one side of the electrode-presser member, while there is not observed any crack when using the electrode-presser member the whole surface of which are completely covered with a plasma sprayed-film.

### Industrial Applicability

The method according to the present invention permits the reduction of the amount of any etching product formed during the dry etching process and in turn permits the achievement of excellent in-plane etching uniformity with respect to the object to be etched. Therefore, the method of the present invention can be used in the field of dry etching techniques, for instance, in the field of semiconductor device-manufacturing techniques.

## Claims

1. A dry etching method which comprises the steps of placing a substrate on an electrode disposed within a vacuum chamber and then subjecting the substrate to dry etching, wherein the dry etching step is carried out using an electrode provided with an electrode-presser member which at least comprises a surface layer composed of an yttrium-containing oxide and which is disposed on the peripheral region of an upper surface of the electrode.

2. The dry etching method as set forth in claim 1, wherein the electrode-presser member is a member completely constituted by an yttrium-containing oxide or it is a member, the entire surface of which is covered with a film of an yttrium-containing oxide.

3. The dry etching method as set forth in claim 1, wherein the electrode-presser member is one constituted by quartz, Al₂O₃ or AlN, the whole surface of which is covered with a film of an yttrium-containing oxide.

4. The dry etching method as set forth in any one of claims 1 to 3, wherein the electrode-presser member is one manufactured by forming a film of an yttrium-containing oxide on the whole surface of an electrode-presser member, according to a spraying technique, a CVD technique or a sputtering technique.

5. The dry etching method as set forth in claim 1, wherein the electrode-presser member is one constituted by a sintered body of an yttrium-containing oxide.

6. The dry etching method as set forth in any one of claims 1 to 5, wherein the yttrium-containing oxide is an yttrium oxide and its purity falls within the range of from 99.5 to 99.9%.

7. The dry etching method as set forth in any one of claims 1 to 6, wherein the yttrium-containing oxide is transparent Y₂O₃.
